# EUROPEAN PATENT APPLICATION

(11) **EP 0 555 576 A1**
(43) Date of publication of application: **18.08.1993**
(21) Application number: 92304183.4
(22) Date of filing: 08.05.1992
(51) Int. Cl.: B23Q 3/155

(54) **Machining apparatus with rotatable tool carousel having interchangeable magazines and method of using same**

(30) Priority: 11.02.1992 US 835734
(71) Applicant: EXCELLON AUTOMATION, Torrance, California 90509 (US)
(72) Inventor: Hall, Hendley W., San Pedro, California 90731 (US)
(74) Representative: Sommerville, John Henry

(57) **Abstract**

An improved tool storage device for use with a computer-controlled machining apparatus such as a drilling machine (10). The preferred embodiment comprises a rotatable carousel (18) having a plurality of tool storage stations (44) positioned radially about the carousel (18) and rigidly secured thereto. The tool stations (44) are being configured to slidably receive a substantially planar, interchangeable tool storage magazine (48) such that said magazines are oriented normal to the axis of rotation of said carousel (18). The tool storage magazines (48) comprise a plurality of tool storage sites (52) arranged in a matrix fashion. A retractable locking mechanism (60) is mounted to the machining apparatus (10) and engaged to the tool carousel (18) so as to lock said tool storage carousel in an indexed position.

## Description

### Field of the Invention

The following invention relates to an improvement on a machining apparatus in general and, in particular, an automatic, computer-controlled drilling machine having improved tool storage capabilities.

### Background of the Invention

Improved operation of machining and processing equipment is a continuous concern of those in the manufacturing industry. One of the problems affecting processing inefficiency is equipment down-time associated with the replacement of worn or broken components, such as the machining tools themselves. For example, with a conventional drilling machine used repeatedly to generate holes in a stack of workpieces, such as printed circuit boards, it becomes necessary to change the drill rather frequently due to rapid wear. Depending upon the type of workpiece material, the length of the period between tool replacement varies. In any case, the machining operation must temporarily cease while a replacement drill is sought and exchanged with the worn bit.

Continuous attempts have been made to minimize down-time so as to maximize efficiency of any one particular machining operation. One of the more common methods for addressing this particular problem is to provide tool storage capability locally within the machining apparatus as well as a tool replacement system. Often times this entails providing a tool storage system that is readily accessible to a tool transferring mechanism positioned between the work unit, such as a spindle assembly, and the tool storage system. This feature is particularly appropriate for computer-controlled drilling machines which are capable of providing some means of automatic tool transfer in order to reduce manual intervention during the machining operation.

Before discussing some of the presently available tool storage systems, it is appropriate to first discuss the features of a conventional prior art drilling machine to which various tool storage systems are typically applied. Specifically, a drilling machine of the type contemplated by the present invention comprises an apparatus having a frame for supporting a horizontally-movable work table and one or more work units, such as spindle assemblies. The spindle assemblies are positioned above the work table in a vertically movable fashion and include a collet at the lower end for rotatably supporting a machining tool such as a drill.

The work table is configured to support one or more stacks of sheet material workpieces, such as circuit boards, below the spindle assemblies. The work table is supported in a manner so as to be translatable in two directions within a horizontal plane. With some drilling machines, the work table is movable only in a first horizontal direction while the spindle assembly and tool storage system are movable collectively in a second horizontal direction normal to the first direction. It is intended that the work table, which supports the workpieces, be movable to a desired location to bring the workpieces into position to be engaged by the machining tool.

Surrounding the collet on each spindle assembly is a stabilizing collar or pressure foot, as it is often referred, which is also vertically movable independent of the spindle assembly and collet. The pressure foot provides stability to the workpieces during the machining operation by applying continuous pressure on the workpieces against the work table so as to preclude undesired movement of the workpieces when the machining operation is in progress.

Adjacent to the work table is one or more tool transfer mechanisms associated with each spindle assembly. The tool transfer mechanisms provide the means for retrieving and exchanging replacement machining tools between the spindle assembly and a tool storage system. Each of the transfer mechanisms are horizontally moveable integrally with the work table and include retractable gripping fingers which are movable in the vertical direction. The gripping fingers are configured to tightly grasp a collar which is frequently provided on the shank of the drills in order to effect transfer of the drill between the tool storage system and the collet of the spindle assembly. Where collarless drill bits are used, differently-configured gripping fingers are employed in order to directly grasp the shank of the drill bit.

Regarding the tool storage systems themselves, the storage of a plurality of interchangeable work tools in an accessible position to a work unit has been accomplished by various means and configurations. One particular form of tool storage system is disclosed in U.S. Patent No. 4,520,551 to Imhof. There a stationary tool magazine support is shown positioned proximate to a work unit (spindle assembly) and is configured to receive tool storage magazines each of which are capable of storing numerous replacement tools in a matrix format. The Imhof tool storage magazines are interchangeable so as to readily increase the number of available replacement machining tools associated with the particular machining apparatus. Imhof also discloses providing a separate tool magazine for each of a plurality of adjacent work units.

The disadvantage of the Imhof apparatus, as well as some other tool storage systems, is that the number of readily available replacement tools is still limited. For example, it should be appreciated that the machining of numerous stacks of workpieces such as printed circuit boards typically requires the drilling of literally hundreds, sometimes thousands, of holes. Expectedly, the drills become worn rather frequently, thereby requiring ready availability of numerous replacement drills in order to maximize the efficient processing of sizable work orders. It would be an improvement to significantly increase the number of available replacement tools accessible to a transfer mechanism adjacent the work unit so as to minimize manual handling and maximize efficient machining operation.

In many cases, the desire to increase the number of available replacement tools has been satisfied by providing some form of recirculating mechanism for exposing one of numerous magazines, each having a plurality of tools stored therewithin, to a transfer area. Such a device is disclosed in the patent to Norota, U.S. Patent No. 4,590,662. There, the machining apparatus includes a main magazine body having a plurality of removable magazines in which the magazine body is rotatable between numerous positions. Supplementing the main magazine body is an auxiliary rotating magazine body, also containing a plurality of removable magazines. Norota discusses transferring magazines from the auxiliary magazine body to the main magazine body in order to increase the number of available tools. However, the Norota device is cumbersome at best, and still only provides a limited number of accessible replacement tools at any one time. In addition, such a storage system requires a more complicated transferring mechanism between the work unit and the tool storage area than is otherwise desired or available with many present machining apparatuses.

Another machining device having multiple tool storage magazines is disclosed in the patent to Novak, U.S. Patent No. 4,783,902. There, a plurality of vertically oriented tool magazines is shown arranged about the perimeter of a rotatable cylinder. While the Novak device incorporates an auxiliary tool storage body into the system, the Novak device is also quite cumbersome and is still limited in the number of available replacement tools it can effectively provide. In addition, the proposed configuration of Novak necessitates a rather cumbersome transfer device which undesirably requires additional room. When used with computer-controlled machining devices having multiple work units, the Novak device becomes impractical.

In light of the above prior art systems, it would be an improvement to provide increased tool storage capability so as to minimize down-time without simultaneously adding to the complexity of the machining device nor the space required to house and operate a replacement tool storage system. The present invention represents an improvement on the above-described machining apparatus by providing a more effective and efficient tool storage system, as will be appreciated from the description below.

### Summary of the Invention

The present invention overcomes previous difficulties in dealing with improved replacement tool storage capability by providing an improved tool storage and retrieval system which is specifically adapted for use with computer-controlled machining apparatuses, such as the drilling machine described above. The preferred embodiment comprises a rotatable carousel having a plurality of tool storage stations. For multiple work units, such as spindle assemblies, it is contemplated that a rotatable carousel will be provided for each work unit. It is also contemplated that each rotatable carousel be identical in configuration and function.

The rotatable carousel of the present invention is oriented horizontally with its axis of rotation being parallel with the horizontal work table positioned below the carousel. The rotatable carousel is supported outwardly from a vertical rear panel attached to the frame of the drilling machine frame so that, at any particular time, one of the plurality of tool storage stations is exposed directly to the work table below. Rotation of the tool storage carousel is preferably caused by a motor positioned within the interior of the carousel. The motor is also preferably responsive to a computer control mechanism, integral with the drilling machine, which automates the machining process.

Associated with the tool storage carousel is a retractable locking mechanism which includes a cylinder and a reciprocating piston mechanically linked to the mid-point of a pivotable arm. A free end of the pivotable arm supports a locking wheel which is engageable with one of several depressions formed in a support plate and positioned between each of the tool storage stations of the carousel. When the carousel has been rotated to bring a particular tool storage station to a desired position for tool retrieval purposes, the locking mechanism can be extended downwardly to engage one of the depressions in the support plate, thereby locking the carousel in place. This locking feature prevents any undesirable movement of the rotatable carousel during tool retrieval and exchange.

In the preferred embodiment, the rotatable carousel comprises five storage stations arranged in a pentagonal fashion, each storage station including a pair of oppositely-disposed U-shaped channels for receiving an interchangeable tool storage magazine. It is contemplated that each tool magazine be of a planar configuration and have a handle at one end for manual exchange with other magazines. It is also contemplated that the interchangeable magazines have a tool storage capacity of approximately 120 machining tools (such as drills) arranged in a matrix fashion.

The tools stored within each magazine are arranged to extend radially outward from the axis of rotation of the rotatable carousel. Storing the tools in this fashion eliminates the need to re-orient the machining tools prior to insertion into the collet of the spindle assemblies. Consequently, when a particular tool storage station is positioned at the bottom of the carousel so that the storage magazine is displayed directly to the work table below, the tools stored in that particular magazine are positioned vertically. This arrangement conveniently exposes the desired tools to the transfer mechanisms positioned below the rotatable carousel.

When a particular tool stored in the carousel is desired for use in a machining operation, the carousel is rotated to the indexed position which brings the desired tool to a vertical orientation at the bottom of the carousel. One of the transfer mechanisms can then be directed to a position directly below the desired tool for withdrawing the tool from the magazine and carrying it to the spindle assembly unit for tool exchange. The used machining tool may then be returned to the storage carousel and placed in an available storage location. If necessary, the carousel must first be rotated to expose an available storage location to the transfer mechanism for insertion of the used tool.

When an entire magazine of replacement tools has been exchanged for worn or broken tools, the magazine itself can be readily replaced with another interchangeable magazine filled with a new set of replacement tools without requiring the interruption of the machining process. The operator merely grasps the magazine by the handle and removes it from the tool storage station. A substitute magazine may then be readily inserted in its place.

As indicated above, when processing machining-intensive workpieces such as printed circuit boards, the drills need to be replaced frequently. The provision of multiple tool storage magazines which can be readily exchanged without interrupting the machining operation or the transfer of tools from other storage magazines constitutes a significant improvement over the prior art. Furthermore, providing a plurality of storage magazines which can be readily displayed to the transfer mechanisms by simply rotating a carousel presents an additional advantage.

As will be described below in more detail, the present invention minimizes down time associated with tool replacement. In addition, it maximizes the efficiency of machining operations by decreasing the amount of manual attention necessary to replenish the supply of replacement tools while simultaneously increasing the amount of tools which can be stored effectively and efficiently on a machining apparatus. Finally, the present invention improves upon the prior art by providing a less cumbersome and space-consuming tool storage system in the form of a rotating carousel. These and other advantages will be appreciated from the detailed description of the invention below in association with the following figures.

### Brief Description of the Drawings

Figure 1 is a front view of a drilling machine according to the present invention showing a plurality of spindle assemblies and associated rotatable carousels.

Figure 2 is a perspective view of a drilling machine according to the present invention showing a rotatable carousel in the foreground and a work unit in the background, with a work table positioned below.

Figure 3 is a front view of the rotatable carousel of Figure 2 showing five tool storage stations arranged in a pentagonal fashion.

Figure 4 is a side sectional view of the rotatable carousel of Figure 3 taken through line 4-4 showing a motor positioned within the rotatable carousel.

### Detailed Description

Reference is now made to the individual figures wherein like components will be designated by like numerals throughout.

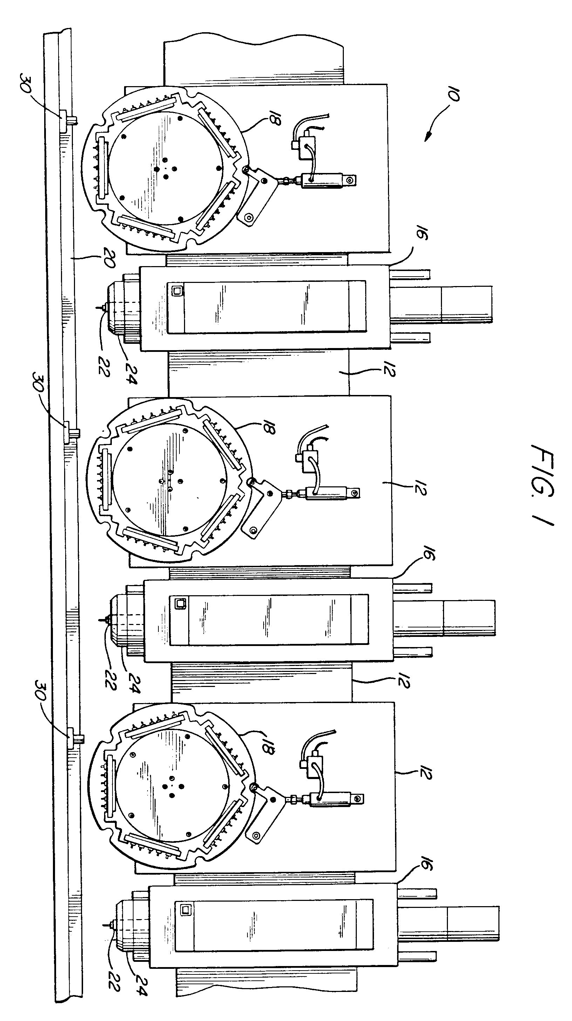

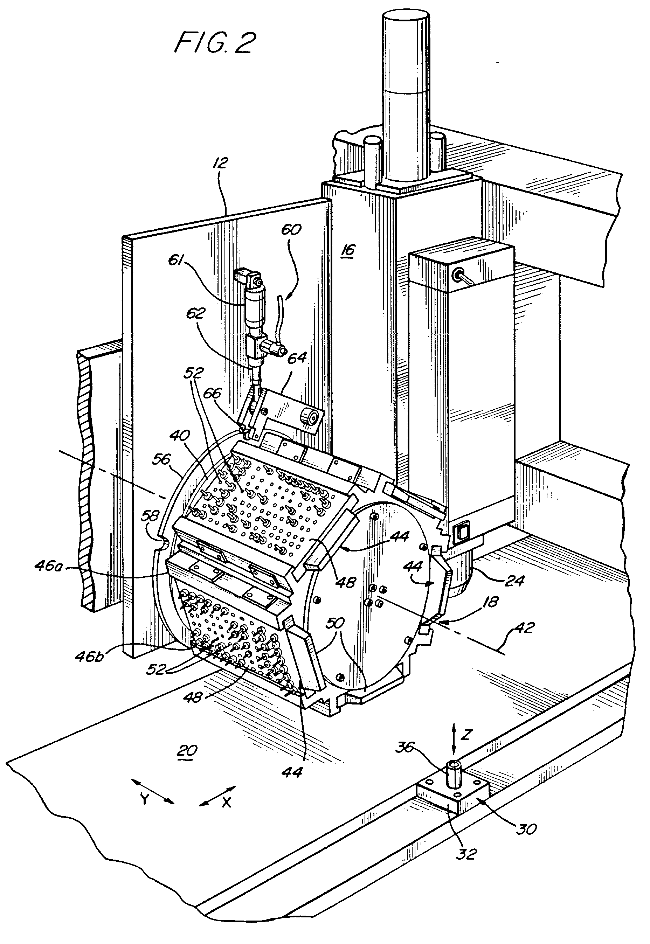

Referring first to Figure 1, a machining apparatus is shown comprising, preferably, a computer-controlled drilling machine 10 having a frame 12 with a rear vertical panel for supporting a number of components. The drilling machine also includes a plurality of work units which are vertically-oriented spindle assemblies 16. Associated with each of the spindle assemblies 16 is an improved tool storage system 18 which is configured to store and readily display a large quantity of replaceable tools for use with the spindle assemblies 16. Since it is intended that each of the tool storage systems 18 be identical in configuration, a representative tool storage system 18 will be described below, particularly in association with Figures 2-4.

As is best seen in Figure 2, positioned below each of the spindle assemblies 16 and the tool storage systems 18 is a work table 20 movable horizontally in the X-Y plane as indicated by the arrows. The work table 20 is designed to support a plurality of work pieces (not shown) which may be, by way of example, a stack of circuit boards.

Referring back to Figure 1, the spindle assemblies 16 of the present invention comprise vertically-oriented shafts which are rotatable and include a collet 22 at their base for gripping a machining tool or drill (not shown) therewithin. Surrounding the collet 22 is an annular collar, commonly referred to as a pressure foot 24, which functions to maintain continuous downward contact with the workpieces during the machining operation so as to prevent undesired movement of the workpieces. Both the collet 22 and pressure foot 24 are moveable in a vertical direction or Z-axis direction, yet capable of independent reciprocal movement.

Positioned integrally within the work table 20 are a plurality of transfer mechanisms 30 which provide the means for transferring replacement tools between the tool storage system 18 and the spindle assemblies 16. Preferably, one transfer mechanism 30 is provided for each of the spindle assemblies 16.

Referring now to Figure 2, an enlarged perspective view of a single spindle assembly 16, a tool storage system 18 and a transfer mechanism 30 can be seen and described in more detail. The preferred embodiment of the transfer mechanism 30 comprises a support housing 32 having an opening for slidably receiving fingers 36 which reciprocate vertically in the Z-direction as indicated by the arrow. The fingers are configured to snugly grasp a drill which frequently includes a collar on the drill shank for handling purposes. An example of the preferred embodiment of the transfer mechanisms 30 may be found on a prior art drilling machine manufactured by the assignee, Excellon Automation of Torrance, California, Model No. Concept IV.

As explained above, the preferred embodiment of the present invention is computer-controlled and thus can be programmed to automatically exchange worn or used tools with replacement tools after a preselected number of machining operations. If the frequency with which tools must be replaced is high, a significant supply of readily available replacement tools as well as an efficient system for the transfer and exchange of tools is required. For example, the fabrication of printed circuit boards requires that literally hundreds of holes be drilled in each of the boards. When multiplied by the number of printed circuit boards provided in a stack of boards machined simultaneously as well as the number of stacks processed daily, it becomes apparent that the drills will wear or break often. As such, it is necessary to replace the used drills on a rather frequent basis.

Referring still to Figure 2, the tool storage system 18 can be described in more detail. There it is shown that the tool storage system 18 of the present invention comprises a rotatable tool storage carousel 40 supported from the rear vertical panel of the frame 12. In the preferred embodiment, the storage carousel 40 is rotatable about a horizontal axis 42, which is parallel with the upper surface of the work table 20. As can also be seen in Figure 2, a plurality of tool storage stations 44 are positioned radially about the circumference of the rotatable carousel 40 and are rigidly secured thereto. In the preferred embodiment, the tool storage stations 44 are oriented normal to the horizontal axis 42. Each tool storage station 44 is comprised of two opposing U-shaped channels 46a and 46b which are spaced apart to slidably receive interchangeable tool storage magazines 48.

The storage magazines 48 comprise a flat board having side edges which mate with the channels 46a, 46b. Preferably, a plurality of spring-biased rollers (not shown) are provided on the side edges of the storage magazines 48 to snugly engage corresponding detents (not shown) on the inside face of the channels 46a, 46b. Furthermore, a plurality of stops (not shown) are provided on the inside face of the channels 46a, 46b to maintain proper position and alignment of the magazines 48 in the storage stations 44. The engagement of the rollers with the detents also ensures that the 48 magazines remain stationary when inserted in the storage stations 44.

On the front edge of the storage magazines 48 is a handle 50 which facilitates manual insertion and removal of the storage magazine 48 into the tool stations 44. A plurality of circular openings in the magazine 48 form tool storage sites 52 into which replacement tools may be inserted. In the preferred embodiment, the magazines 48 are of plastic construction and include about 120 such storage sites 52 arranged in a matrix fashion. In addition, as indicated above, each tool storage station 44 is configured to permit the manual removal of one storage magazine 48 for replacement by a substitute storage magazine having a different set of replacement tools stored therein. Each storage site 52 includes a short-length split sleeve (not shown) which in integrally constructed on one side of the magazines 48. The split sleeve is concentrically aligned with the opening which form the storage site 52 so as to snugly receiving an end shank portion of a replacement tool. The split sleeve provides a means for retaining the tools within the storage magazines 48 until they are retrieved for later use.

Positioned at the rear portion of the rotatable carousel 40 is a vertically-oriented, substantially-circular support plate 56. The support plate 56 includes a plurality of indexing positions which are preferably formed by semicircular depressions 58 disposed about the perimeter of the support plate 56 between each individual tool storage station 44. The depressions 58 are configured to receive a corresponding element in a retractable locking mechanism 60 which is secured to the rear panel 12 and is positioned above the rotatable carousel 40. In the preferred embodiment, the retractable locking mechanism 60 comprises a cylinder 61 with a reciprocating, preferably pneumatically-operated, piston 62 which pivotally engages the mid-portion of an L-shaped arm 64. The arm 64 is pivotably secured at one of its ends to the rear panel 12 at a pivot point 66. A locking wheel 68 is supported to the opposite end of the arm 64, distal from its pivot point 66. The wheel 68 is configured to engage one of the plurality of semicircular depressions 58 so as to secure the rotatable carousel 40 in a locked position and avoid undesired movement of the rotatable carousel 40 during the tool transfer operation. In the preferred embodiment, the locking arm 64 comprises two discrete L-shaped plates which are spaced apart and sandwich the locking wheel 68 therebetween.

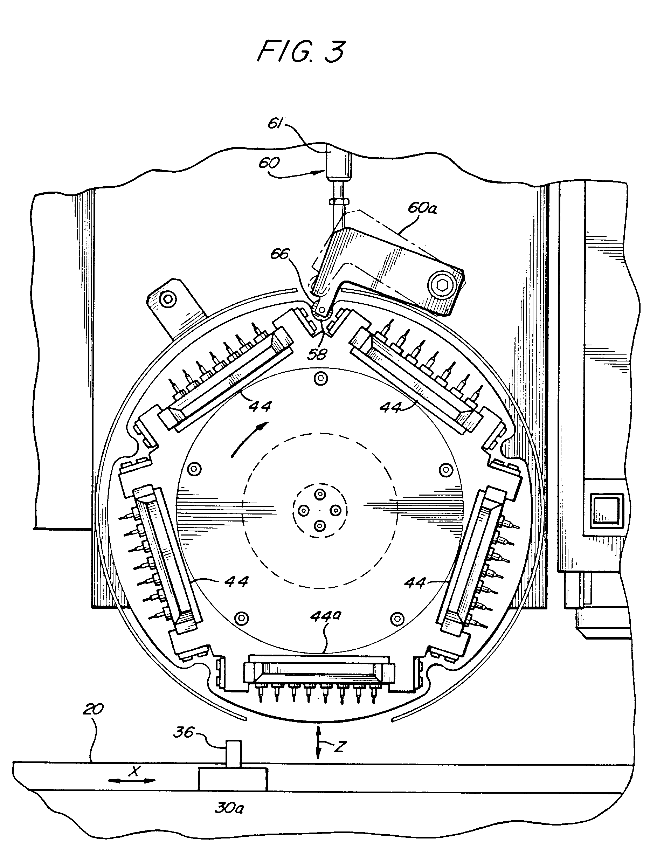

Referring now to Figure 3, the preferred embodiment of the rotatable carousel 40 can be seen as comprising five tool storage stations 44 arranged in a pentagonal fashion so that at least one tool storage station 44a is always in a position downwardly facing the work table 20. It should be noted that the present invention is not limited to five storage stations 44, but rather may include any number of tool storage stations which effectively displays replacement machining tools to the transfer mechanisms.

In Figure 3, the lower tool storage station 44a is shown at the bottom of the rotatable carousel 40 downwardly facing the transfer mechanism 30 and its associated gripping fingers 36 extending upwardly. As alluded to above, while the transfer mechanism 30 moves in the horizontal X-Y plane, the gripping fingers 36 reciprocate vertically in the Z-direction. When a tool exchange is desired, the rotatable carousel 40 is directed to the position shown in Figure 3 so that the desired replacement tool is positioned downwardly facing the transfer mechanism 30. While the carousel 40 is being rotated, the locking mechanism 60 is returned to its retracted position 60a, as shown in Figure 3 by broken lines, to permit free movement of the carousel 40. After the carousel 40 has been rotated to the position desired, the retractable locking mechanism 60 can then be activated so that the locking wheel 66 engages the top depression 58a positioned directly opposite the tool storage station 44a below.

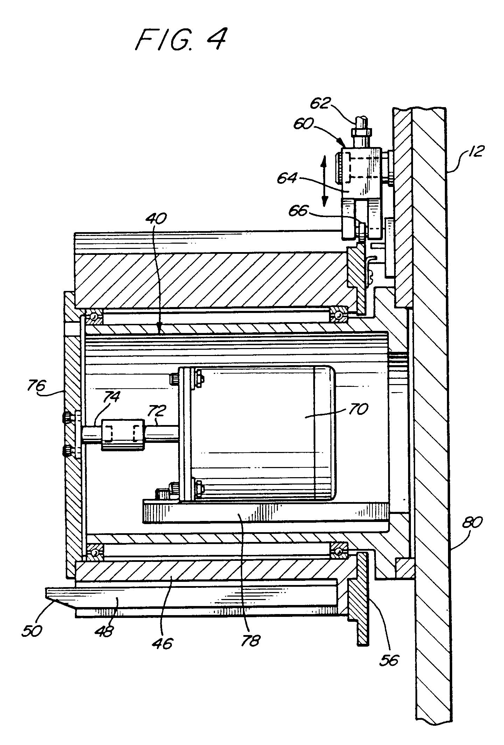

Referring now to Figure 4, it can be appreciated that the tool storage carousel 40 is rotated by an electric motor 70 preferably housed within the interior of the carousel 40. In the preferred embodiment, the motor 70 includes a motor shaft 72 which is coupled to a drive shaft 74 secured to the interior rear face of a cover plate 76. The cover plate 76 is mechanically secured to the storage carousel 40 so that rotation of the motor shaft 72 causes rotation of the rotatable carousel 40 by the transfer of torque through the drive shaft 74 and cover plate 76. As shown, the motor 70 is supported by a ledge 78 which itself is supported in a cantilever fashion from a carousel housing 80 which is, in turn, secured to the rear panel 12.

Having identified the components of the tool storage system and transfer mechanisms, the transferring operation may now be explained in more detail in association with Figure 2. As a preliminary matter, it is to be noted that while multiple transfer mechanisms can be effective at exchanging a used drill with a replacement drill, the preferred embodiment of the present invention provides only a single transfer mechanism 30 for each working unit 16 in order to maximize efficiency. By way of example, the transfer mechanism 30, which is shown in Figure 2 in a standby position at the front of the work table 20, can be manipulated as follows.

When it is desired to replace a worn or broken tool (drill) in the spindle assembly 16, the transfer mechanism 30 (for each spindle assembly) can be positioned below the collet 22 of the spindle assembly to withdraw the used tool. The transfer mechanism 30 is then relocated to below the tool storage carousel 40 so that the used tool can be inserted into an available storage site 52. The carousel 40 is rotated an amount necessary to bring a magazine 48 with an available storage site into the lower position directly facing the work table 20 below. The transfer mechanism 30 is then positioned in alignment with the storage site of the tool station 44a. The gripping fingers 36 of the transfer mechanism 30 can then be extended upwardly toward the tool station 44a so as insert the used tool within the storage site. The gripping fingers 36 are then retracted to avoid obstructing rotation of the carousel. The carousel 40 can then be rotated an amount necessary to bring a replacement tool within a tool station 44 into the lower tool station position 44a. The transfer mechanism 30 is then positioned in alignment with the replacement tool. The gripping fingers 36 of the transfer mechanism 30 can then be extended upwardly toward the tool station 44a so as to grasp and retrieve the desired replacement tool. With the replacement tool secured in the gripping fingers 36, the transfer mechanism is directed horizontally to below the spindle assembly 16 and alignment therewith. When positioned correctly, the gripping fingers of the transfer mechanism 30 can then be extended upwardly to insert the replacement tool into the collet 22.

With the present invention, down time in machining operations is minimized by providing a means for efficiently transferring worn machining tools from work units to a tool storage system. In addition, the tool storage system of the present invention improves upon the prior art by increasing the number of readily available replacement tools and more efficiently displaying the tools to the transfer mechanism. Still further, the present invention is easily adaptable to conventional drilling machines and the like without sacrificing significant working space.

The invention may be embodied in other specific forms without departing from its spirit or essential characteristics. The described embodiment is to be considered in all respects only as illustrative and not restrictive and the scope of the invention is, therefore, indicated by the appended claims rather than by the foregoing description. All changes which come within the meaning and range of equivalency of the claims are to be embraced within their scope.

## Claims

1. A tool storage system for a machining apparatus configured to machine at least one workpiece, said apparatus including a spindle assembly for supporting a machining tool in a manner such that the machining tool may be brought into engagement with the workpiece in order to perform a machining operation on said workpiece, said apparatus also including a work table positioned below the spindle assembly and configured to support said workpiece thereon, said work table being movable in a horizontal plane to bring said workpieces into alignment with said spindle assembly for a machining operation, said apparatus further including at least one transfer mechanism positioned within the work table and below the spindle assembly, said transfer mechanism being translatable in a horizontal plane so as to be aligned with the spindle assembly when so desired, said tool storage system comprising:
a rotatable tool storage carousel having a plurality of tool stations positioned radially about the carousel and rigidly secured thereto, the tool stations including means for receiving a removable tool storage magazine, each tool storage magazine including a plurality of tool storage sites for storing a machining tool therein; and
a locking system for retractably locking the tool storage carousel in an indexed position.

2. The device of Claim 1 wherein the locking system comprises a cylinder and piston mechanically linked to a pivotable arm wherein said arm is engageable with the storage carousel.

3. The device of Claim 1 wherein said transfer mechanism includes retractable gripping fingers for grasping said machining tool to effectuate transfer of said machining tool to and from said spindle assembly.

4. A tool storage device adapted to be used on a machining apparatus, said tool storage device comprising:
a tool storage carousel rotatable about a horizontal axis;
a plurality of tool storage stations positioned radially about the circumference of the carousel and rigidly secured thereto, said plurality of tool stations each including means for receiving a removable tool storage magazine therein, said tool storage magazine including means for manually removing said tool storage magazine from said receiving means;
a plurality of tool storage sites provided on the tool storage magazine, said storage sites each formed by an opening in said storage magazine and adapted to retain a single machining tool therein; and
a retractable locking mechanism mounted to the machining apparatus and engageable with the tool carousel so as to lock said tool storage carousel in an indexed position.

5. A method of automatically exchanging a used machining tool with a replacement machining tool in a machining apparatus, said machining apparatus including a work table, a work unit, a transfer mechanism, and a rotatable tool carousel, said rotatable tool carousel being positioned proximate to the work unit and having a plurality of tool storage stations positioned radially about the carousel and rigidly secured thereto, said tool storage stations having a plurality of tool storage sites each configured to store one replacement tool therein, said storage stations also having at least one unoccupied tool storage site for the receipt of a machining tool, said machining apparatus further including a retractable locking mechanism for retractably locking the tool storage carousel in an indexed position, said method comprising the steps of:
removing the used tool from the work unit;
rotating the tool carousel to a position so as to bring an unoccupied tool storage site to an accessible position;
inserting the used tool into the unoccupied tool storage site within the tool carousel;
rotating the tool carousel to a position so as to bring a desired replacement tool to an accessible position if the replacement tool is stored in a different storage station than is the said unoccupied tool storage site, and
removing the replacement tool from the storage carousel.
inserting the replacement tool into the work unit.

6. A method of automatically exchanging a used machining tool with a replacement machining tool in a machining apparatus, said machining apparatus including a work table, a work unit, a transfer mechanism, and a rotatable tool carousel, said rotatable tool carousel being positioned proximate to the work unit and having a plurality of tool storage stations positioned radially about the carousel and rigidly secured thereto, said tool storage stations having a plurality of tool storage sites each storing one replacement machining tool therein, said storage stations also having at least one unoccupied tool storage site for the receipt of a machining tool, said machining apparatus further including a retractable locking mechanism for retractably locking the tool storage carousel in an indexed position, said method comprising the steps of:
rotating the tool carousel to a position so as to expose a replacement machining tool to the transfer mechanism;
removing the replacement machining tool from the tool carousel;
exchanging the replacement machining tool with a used machining tool in the work unit;
rotating the tool carousel to a position so as to expose an available tool storage site to the transfer mechanism;
inserting the used tool into the available tool storage site.
